# EUROPÄISCHE PATENTSCHRIFT

(11) **EP 4 001 935 B1**
(45) Veröffentlichungstag und Bekanntmachung des Hinweises auf die Patenterteilung: **08.04.2026**
(21) Anmeldenummer: 20208573.4
(22) Anmeldetag: 19.11.2020
(51) Int. Cl.: G01R 31/12, G01R 31/72

(54) **VERFAHREN ZUR STOSSSPANNUNGSPRÜFUNG EINES ELEKTRISCHEN SYTEMS**
METHOD FOR TESTING AN ELECTRICAL SYSTEM FOR SURGE VOLTAGE
PROCÉDÉ D'ESSAI DE TENSION DE CHOC D'UN SYSTÈME ÉLECTRIQUE

(43) Veröffentlichungstag der Anmeldung: 25.05.2022
(73) Patentinhaber: Schleich GmbH, 58675 Hemer (DE)
(72) Erfinder: LAHRMANN, Jan-Philipp, 58675 Hemer (DE); LAHRMANN, Elmar, 58675 Hemer (DE)
(74) Vertreter: Fritz Patent- und Rechtsanwälte PartmbB

(56) Entgegenhaltungen:
- EP-A1- 0 543 316
- DE-A1- 102018 202 358
- GB-A- 2 530 716
- US-A- 3 869 664

## Beschreibung

Die vorliegende Erfindung betrifft ein Verfahren zur Stoßspannungsprüfung eines elektrischen Systems gemäß dem Oberbegriff des Anspruchs 1.

Aus dem Stand der Technik sind solche Verfahren bekannt. Sie werden eingesetzt, um bei elektrischen Systemen mit Spulen, wie beispielsweise Elektromotoren oder Generatoren, Windungsschlüsse und Isolationsfehler innerhalb einer Wicklung zu detektieren. Zu diesem Zweck wird ein geladener Kondensator relativ schnell parallel zu der zu prüfenden Wicklung geschaltet. Dies erzeugt für eine relativ kurze Zeit eine relativ hohe Spannung in der Wicklung. Die im Kondensator gespeicherte Energie entlädt sich in die Induktivität. Die dann in der Induktivität gespeicherte Energie entlädt sich wieder in den Kondensator. Aufgrund von Dämpfungsverlusten ist dieser Vorgang an den Anschlüssen der Wicklung als gedämpfte Schwingung zu messen. Wenn die Amplitude unter einen bestimmten Grenzwert gefallen ist oder nicht mehr messbar ist, kann der Vorgang als abgeschlossen angesehen werden. Aus dem Verlauf der gedämpften Schwingung können Rückschlüsse auf die Qualität der Wicklung gezogen werden. Bei einer intakten Wicklung hat die Schwingung eine typische Frequenz und einen charakteristischen Amplitudenverlauf. Falls es zu große Abweichungen von dieser Frequenz und diesem Amplitudenverlauf gibt, kann die Wicklung als fehlerhaft detektiert werden.

Aus US 3 869 664 A ist ein Stoßspannungsprüfgerät bekannt, das gleichzeitig gegensätzlich polarisierte Stoßspannungsimpulse an eine Prüfwicklung und eine Standardwicklung anlegt. Wenn die elektrischen Eigenschaften der beiden Wicklungen asymmetrisch sind, wird eine Differenzspannung, die der Differenz der an den Wicklungen entwickelten Spannungen entspricht, an eine Fehlererkennungsschaltung angelegt. Wenn die Asymmetrie groß genug ist, wird ein Fehler angezeigt.

Demgegenüber liegt der vorliegenden Erfindung die Aufgabe zugrunde, eine Wiederholrate für das mehrmalige Durchführen des Verfahrens zu erhöhen.

Diese Aufgabe wird durch ein Verfahren gemäß Anspruch 1 und durch eine Vorrichtung gemäß Anspruch 11 gelöst. Ausführungsformen der Erfindung sind in den abhängigen Ansprüchen angegeben.

Zunächst wird ein elektrischer Spannungsstoß an das zu prüfende elektrische System, beispielsweise eine Windung eines Elektromotors oder eines Generators, über zumindest zwei elektrische Kontakte des elektrischen Systems abgegeben. Der Spannungsstoß kann beispielsweise abgegeben werden, indem ein Kondensator parallel zur Windung geschaltet wird. Dabei kann die Amplitude des Spannungsstoßes innerhalb von 50ns bis 1µs nach Schalten des Kondensators erreicht sein. Es handelt sich somit um eine relativ hohe Spannung, die bei Schaltung des Kondensators in sehr kurzer Zeit erreicht wird.

Die Abgabe des Spannungsstoßes wird durch eine Schaltung von Halbleiterelementen in einen ersten Zustand ausgelöst. Die Halbleiterelemente können dabei beispielsweise kaskadiert sein. Dies ist vorteilhaft, um einen Spannungsstoß mit besonders hoher Spannung zu erzeugen. Die Halbleiterelemente verbinden im ersten Zustand einen elektrischen Energiespeicher, beispielsweise einen Kondensator, mit dem elektrischen System. Es ist insbesondere möglich, dass der Energiespeicher im ersten Zustand der Halbleiterelemente parallel zu dem elektrischen System geschaltet ist.

Bei den Halbleiterelementen kann es sich beispielsweise um Transistoren, insbesondere um Bipolartransistoren, Bipolartransistoren mit isolierter Gate-Elektrode (IGBT), Feldeffekttransistoren, Metall-Oxid-Halbleiter-Feldeffekttransistoren, Sperrschicht-Feldeffekttransistoren und/oder Silizium-Carbid-Feldeffekttransistoren handeln. Die Halbleiterelemente weisen jeweils einen Gate-Anschluss auf. Wenn die Halbleiterelemente in den ersten Zustand geschaltet werden, wird jeweils eine Kapazität am Gate-Anschluss aufgeladen.

Ein Spannungsverlauf wird zwischen den beiden elektrischen Kontakten direkt nach der Abgabe des Spannungsstoßes gemessen. Es ist insbesondere möglich, dass während und direkt nach der Abgabe des Spannungsstoßes der Spannungsverlauf gemessen wird. Der Spannungsverlauf umfasst dabei eine gedämpfte Schwingung. Die Schwingung kann beispielsweise sinusförmig sein. Der Spannungsverlauf kann insbesondere aus der gedämpften Schwingung bestehen.

Der gemessene Spannungsverlauf wird analysiert, um Teilentladungen im elektrischen System zu detektieren. Die Detektion solcher Teilentladungen lässt insbesondere auch Rückschlüsse auf die Qualität des elektrischen Systems zu.

Die gedämpfte Schwingung wird aktiv abgebrochen. Unter einem aktiven Abbruch wird dabei im Rahmen dieser Beschreibung insbesondere verstanden, dass der Vorgang, der die Schwingung verursacht, unterbrochen wird. Dies kann beispielsweise bedeuten, dass die elektrische Verbindung des elektrischen Systems mit einem Energiespeicher getrennt wird. Der Energiespeicher kann beispielsweise ein Kondensator sein, der zur Abgabe des Spannungsstoßes parallel zum elektrischen System geschaltet worden ist. Ein aktiver Abbruch soll explizit nicht darin bestehen, dass gewartet wird, bis die Amplitude der Schwingung so stark gedämpft wurde, dass sie nicht mehr messbar ist.

Zusätzlich zum aktiven Abbruch der gedämpften Schwingung können die Kapazitäten an den Gate-Anschlüssen aktiv entladen werden. Dies ist vorteilhaft, um die Halbleiterelemente besonders schnell wieder in einen zweiten Zustand schalten zu können, in dem der elektrische Energiespeicher vom elektrischen System getrennt ist. Wenn es sich bei den Halbleiterelementen beispielsweise um Transistoren handelt, können sie nur dann in den zweiten Zustand geschaltet werden, wenn die Kapazitäten an den Gate-Anschlüssen entladen werden. Erst dann ist es auch möglich, den Energiespeicher wieder für die Abgabe eines weiteren Spannungsstoßes vorzubereiten.

Unter einer aktiven Entladung wird dabei im Rahmen dieser Beschreibung insbesondere verstanden, dass die Gate-Anschlüsse über ein oder mehrere Bauteile entladen werden, die nicht zur Aufladung der Kapazitäten verwendet werden. Dabei kann es sich beispielsweise um einen Entladewiderstand handeln.

Die aktive Entladung kann im Gegensatz zu einigen anderen Einsatzgebieten von Halbleiterelementen nicht durch eine einfache Erdung erfolgen, da die Halbleiterelemente von anderen Komponenten galvanisch getrennt sind. Eine Erdung würde diese aufgrund der hohen Spannungen notwendige galvanische Trennung aufheben.

Durch den aktiven Abbruch der gedämpften Schwingung kann das Verfahren besonders schnell wieder durchgeführt werden. Solange die Schwingung stattfindet, kann der Energiespeicher, der für die Abgabe des Spannungsstoßes genutzt wird, nicht wieder aufgeladen werden, um den nächsten Spannungsstoß abzugeben. Je schneller somit die gedämpfte Schwingung abgebrochen wird, desto eher kann das Verfahren nochmals durchgeführt werden, da der Energiespeicher nach dem Abbruch der Schwingung wieder aufgeladen werden kann. Die aktive Entladung der Kapazitäten hat ebenfalls den Vorteil, dass der Energiespeicher schnell wieder aufgeladen werden kann und die Halbleiterelemente anschließend wieder für die Abgabe des nächsten elektrischen Spannungsstoßes in den ersten Zustand geschaltet werden können. In Produktionsprozessen von Elektromotoren oder Generatoren werden Stoßspannungsprüfungen üblicherweise mehrmals durchgeführt. Die konkrete Anzahl an notwendigen Stoßspannungsprüfungen ist in entsprechenden Normen empfohlen. Falls nun die Schwingung beispielsweise nach weniger als 1 Millisekunde abgebrochen wird und normalerweise mehrere Millisekunden dauert, kann die Wiederholrate für die Stoßspannungsprüfungen dementsprechend gesteigert werden. Somit können beispielsweise 300 Stoßspannungsprüfungen in weniger als 10 Sekunden durchgeführt werden. Es ist sogar auch möglich, 100 Stoßspannungsprüfungen in nur einer einzigen Sekunde durchzuführen. Wenn die gedämpfte Schwingung nicht abgebrochen wird und beispielsweise 20 Millisekunden anhält, werden für die gleiche Anzahl an Stoßspannungsprüfungen mehrere Minuten benötigt. Insbesondere bei der industriellen Produktion von Elektromotoren und Generatoren stellt dies eine enorme Zeitersparnis dar.

Der Abbruch der Schwingung ist ohne Inkaufnahme von Nachteilen möglich, da für die Stoßspannungsprüfung mit zeitgleich durchgeführter Teilentladungsprüfung der Spannungsverlauf nur direkt nach dem Spannungsstoß relevant ist. Wie der Spannungsverlauf weiter verläuft, muss nicht ausgewertet werden, um Fehler im elektrischen System zuverlässig erkennen zu können.

Nach einer Ausführungsform der Erfindung kann die gedämpfte Schwingung nach einer Schwingungsperiode oder nach einer halben Schwingungsperiode abgebrochen werden. Häufig reicht eine Schwingungsperiode oder sogar nur eine halbe Schwingungsperiode für die Stoßspannungsprüfung mit Teilentladungsprüfung aus.

Es ist auch möglich, dass die gedämpfte Schwingung abgebrochen wird, bevor bei der gedämpften Schwingung eine Amplitude von weniger als 100 Volt gemessen wird.

Es ist auch möglich, dass die gedämpfte Schwingung nach weniger als 10 Millisekunden, vorzugsweise nach weniger als 1 Millisekunde abgebrochen wird.

Es ist möglich, dass die Halbleiterelemente einen einzigen Energiespeicher mit dem elektrischen System elektrisch verbinden. Es ist auch möglich, dass die Halbleiterelemente mehrere Energiespeicher mit dem elektrischen System elektrisch verbinden.

Nach einer Ausführungsform der Erfindung können die Halbleiterelemente galvanisch voneinander getrennt sein. Es ist insbesondere möglich, dass die Halbleiterelemente galvanisch voneinander getrennt, beispielsweise in den ersten Zustand, geschaltet werden. Die galvanische Trennung ist vorteilhaft, wenn die Halbleiterelemente kaskadiert verschaltet sind und zur Schaltung sehr hoher Spannungen ausgebildet sind.

Nach einer Ausführungsform der Erfindung kann die gedämpfte Schwingung abgebrochen werden, indem die Halbleiterelemente in den zweiten Zustand geschaltet werden. Wenn die Halbleiterelemente im zweiten Zustand sind, ist die elektrische Verbindung zwischen dem elektrischen Energiespeicher und dem elektrischen System getrennt. So kann der Energiespeicher wieder für die nächste Stoßspannungsprüfung vorbereitet werden, indem er mit elektrischer Energie aufgeladen wird.

Nach einer Ausführungsform der Erfindung können die Halbleiterelemente in den zweiten Zustand geschaltet werden, indem die Kapazität des Gate-Anschlusses jeweils elektrisch entladen wird.

Nach einer Ausführungsform der Erfindung kann die Kapazität des Gate-Anschlusses jeweils über einen Thyristor oder einen Transistor und einen Entladewiderstand entladen werden. Sobald die Entladung der Kapazität des Gate-Anschlusses erfolgen soll, wird der Thyristor oder der Transistor leitend geschaltet, sodass die Entladung der Kapazität des Gate-Anschlusses über den Entladewiderstand erfolgt.

Nach einer Ausführungsform der Erfindung kann die gedämpfte Schwingung nach Ablauf einer Zeitspanne abgebrochen werden. Die Zeitspanne kann durch eine Entladung eines Verzögerungsglieds definiert sein. Unter einem Verzögerungsglied wird dabei im Rahmen dieser Beschreibung insbesondere eine Kombination aus einem Widerstand und einem Kondensator verstanden, die parallel zueinander geschaltet sein können. Beispielsweise kann das Verzögerungsglied nach Ablauf der Zeitspanne einen Entladetransistor schalten, der dann wiederum den Thyristor oder den Transistor leitend schaltet.

Nach einer Ausführungsform der Erfindung kann der Energiespeicher während der Abgabe des Spannungsstoßes nachgeladen werden. Das Verzögerungsglied kann bei einer Nachladung des Energiespeichers ebenfalls nachgeladen werden. Dies führt dazu, dass die Kapazität des Gate-Anschlusses jeweils solange nicht entladen wird, wie der Energiespeicher nachgeladen wird. Somit verbleiben die Transistoren im ersten Zustand, solange der Energiespeicher nachgeladen wird.

Nach einer Ausführungsform der Erfindung kann nach dem Abbruch der gedämpften Schwingung ein weiterer elektrischer Spannungsstoß an das elektrische System über die beiden elektrischen Kontakte des elektrischen Systems abgegeben werden. Dies kann insbesondere in der gleichen Art und Weise erfolgen wie der erste Spannungsstoß. Die wiederholte Abgabe von Spannungsstößen ist vorteilhaft für eine besonders ausgiebige Prüfung des elektrischen Systems. So kann beispielsweise durch Normen vorgegeben sein, wie oft ein bestimmtes elektrisches System geprüft werden muss.

Nach einer Ausführungsform der Erfindung kann der Spannungsstoß eine Spannung von mehr als 500 Volt aufweisen. Die 500 Volt können beispielsweise durch eine Entladung des Energiespeichers innerhalb von weniger als 1 Mikrosekunde erreicht werden.

Die Vorrichtung gemäß Anspruch 12 umfasst mehrere, vorzugsweise kaskadierte, Halbleiterelemente, einen Energiespeicher, Anschlüsse für eine elektrische Verbindung der Vorrichtung mit dem elektrischen System, erste Mittel zur Schaltung der Halbleiterelemente in einen ersten Zustand und zweite Mittel zur Schaltung der Halbleiterelemente in einen zweiten Zustand. Der Energiespeicher kann beispielsweise als Kondensator ausgebildet sein. Im ersten Zustand der Halbleiterelemente ist der Energiespeicher elektrisch mit den Anschlüssen verbunden. Es ist insbesondere möglich, dass der Energiespeicher im ersten Zustand der Halbleiterelemente parallel zum elektrischen System geschaltet ist, wenn das elektrische System an den Anschlüssen angeschlossen ist. Im zweiten Zustand der Halbleiterelemente ist der Energiespeicher von zumindest einem der Anschlüsse getrennt. Die Vorrichtung ist dazu ausgebildet, ein Verfahren nach einer Ausführungsform der Erfindung auszuführen.

Nach einer Ausführungsform der Erfindung können die Halbleiterelemente als Transistoren ausgebildet sein, die einen Gate-Anschluss aufweisen. Die ersten Mittel und die zweiten Mittel können jeweils mit dem Gate-Anschluss der Transistoren elektrisch verbunden sein. Je nachdem, wie der Gate-Anschluss angesteuert wird, kann so der Spannungsstoß abgegeben oder die elektrische Verbindung zwischen dem Energiespeicher und dem elektrischen System gelöst werden.

Nach einer Ausführungsform der Erfindung können die zweiten Mittel dazu ausgebildet sein, jeweils die Kapazität des Gate-Anschlusses der Transistoren elektrisch zu entladen. Hierdurch können die Transistoren in den zweiten Zustand geschaltet werden.

Merkmale, die in Bezug auf Ausführungsformen des Verfahrens beschrieben wurden, können ebenfalls bei Ausführungsformen der Vorrichtung vorgesehen sein.

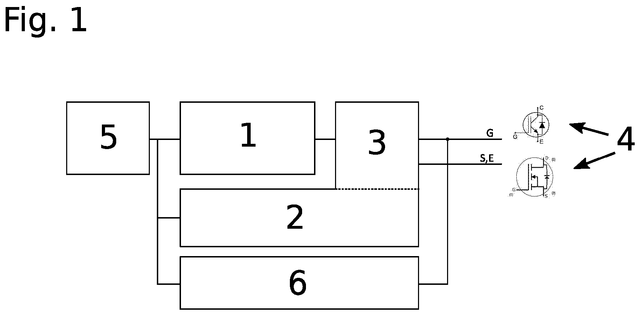

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Dabei werden für gleiche oder ähnliche Bauteile und für Bauteile mit gleichen oder ähnlichen Funktionen dieselben Bezugszeichen verwendet. Darin zeigt
- Fig. 1: ein schematisches Blockschaltbild eines Ausschnitts einer Vorrichtung nach einer Ausführungsform der Erfindung.

Die Vorrichtung umfasst einen Steuerungsenergiespeicher 1. Dies kann beispielsweise ein Kondensator sein. Außerdem umfasst die Vorrichtung eine Triggererkennung 2, eine Gate-Ansteuerung 3, Transistoren 4, eine galvanische Trennung 5 und eine Abschaltelektronik 6.

Der Steuerungsenergiespeicher 1 dient der Ansteuerung der Transistoren 4. Die Transistoren 4 sind elektrisch mit Anschlüssen (in Fig. 1 nicht dargestellt) verbunden, an die ein elektrisches System angeschlossen werden kann, das mit einer Stoßspannungsprüfung geprüft werden soll. Außerdem sind die Transistoren 4 elektrisch mit einem Energiespeicher verbunden (in Fig. 1 nicht dargestellt). Wenn die Transistoren 4 unter Verwendung des Steuerungsenergiespeichers 1 leitend geschaltet werden und das elektrische System an den Anschlüssen angeschlossen ist, ist der Energiespeicher parallel zum elektrischen System geschaltet. Dies kann auch als erster Zustand der Transistoren 4 bezeichnet werden.

Die Triggererkennung 2 ist dazu ausgebildet, ein Triggersignal zu erkennen. Wenn das Triggersignal erkannt wird, veranlasst die Triggererkennung 2 die Gate-Ansteuerung 3 dazu, die Gates der Transistoren 4 anzusteuern, sodass die Transistoren 4 unter Verwendung von Energie aus dem Steuerungsenergiespeicher 1 in den ersten Zustand geschaltet werden. Dann entlädt sich die Energie des Energiespeichers in das elektrische System, wodurch die gedämpfte Schwingung ausgelöst wird. Von nicht dargestellten Messmitteln wird die Frequenz und die Amplitude der gedämpften Schwingung analysiert, wodurch Fehler oder Abweichungen im elektrischen System von einer Norm detektiert werden können.

Nach einer Schwingungsperiode oder sogar nach nur einer halben Schwingungsperiode wird die gedämpfte Schwingung aktiv abgebrochen, indem die Abschaltelektronik 6 die Transistoren 4 in einen zweiten Zustand schaltet, in denen die Transistoren 4 nichtleitend sind. Somit ist der Energiespeicher vom elektrischen System getrennt. Dies kann beispielsweise durch eine Entladung der Kapazitäten der Gate-Anschlüsse der Transistoren 4 erfolgen. Durch diese Entladung werden die Transistoren 4 schneller in den zweiten Zustand geschaltet als es ohne Abschaltelektronik der Fall wäre. So kann der Energiespeicher besonders kurz nach Abgabe des Spannungsstoßes wieder aufgeladen werden, sodass er vergleichsweise schnell wieder zur Abgabe eines weiteren Spannungsstoßes zur Verfügung steht.

Für die Entladung der Kapazitäten der Gate-Anschlüsse der Transistoren 4 weist die Abschaltelektronik 6 einen Thyristor und einen Entladewiderstand auf. Der Thyristor ist mit den Gate-Anschlüssen der Transistoren 4 elektrisch verbunden. Der Thyristor entlädt die Gate-Anschlüsse nach Ablauf einer Zeitspanne über den Entladewiderstand. Die Zeitspanne ist dabei durch die Entladung eines Verzögerungsglieds definiert. Sobald das Verzögerungsglied entladen ist, ist die Zeitspanne abgelaufen. Nach Ablauf der Zeitspanne schaltet das Verzögerungsglied einen Entladetransistor, der wiederum den Thyristor leitend schaltet, sodass die Kapazitäten der Gate-Anschlüsse 4 entladen werden.

Falls der Energiespeicher während der Abgabe des Spannungsstoßes oder während der gedämpften Schwingung nachgeladen wird, wird ebenfalls das Verzögerungsglied daran gehindert, sich zu entladen, sodass auch noch keine Entladung der Kapazitäten der Gate-Anschlüsse erfolgt und die Transistoren 4 im zweiten Zustand verbleiben.

Der Energiespeicher wird dann wieder aufgeladen und ein nächster Spannungsstoß wird in gleicher oder ähnlicher Art und Weise an das elektrische System abgegeben. Da die durch die Spannungsstöße erzeugten gedämpften Schwingungen abgebrochen werden und die Kapazitäten der Gate-Anschlüsse aktiv entladen werden, können in sehr kurzer Zeit viele Stoßspannungsprüfungen durchgeführt werden. Bei der industriellen Produktion von Elektromotoren oder Generatoren lässt sich die für die Stoßspannungsprüfungen benötigte Zeit somit von mehreren Minuten auf wenige Sekunden verringern.

## Patentansprüche

1. Verfahren zur Stoßspannungsprüfung eines elektrischen Systems, umfassend die folgenden Schritte:
- Abgabe eines elektrischen Spannungsstoßes an das elektrische System über zumindest zwei elektrische Kontakte des elektrischen Systems, wobei die Abgabe des Spannungsstoßes durch eine Schaltung von Halbleiterelementen (4) in einen ersten Zustand ausgelöst wird, wobei die Halbleiterelemente (4) im ersten Zustand einen elektrischen Energiespeicher mit dem elektrischen System elektrisch verbinden, wobei die Halbleiterelemente (4) jeweils einen Gate-Anschluss aufweisen, wobei jeweils eine Kapazität am Gate-Anschluss aufgeladen wird, wenn die Halbleiterelemente (4) in den ersten Zustand geschaltet werden;
- Messung eines Spannungsverlaufs zwischen den beiden elektrischen Kontakten direkt nach der Abgabe des Spannungsstoßes, wobei der Spannungsverlauf eine gedämpfte Schwingung umfasst;
- Analyse des gemessenen Spannungsverlauf, um Teilentladungen im elektrischen System zu detektieren; **dadurch gekennzeichnet, dass**
- die gedämpfte Schwingung aktiv abgebrochen wird.

2. Verfahren nach Anspruch 1, **dadurch gekennzeichnet, dass** die Kapazitäten an den Gate-Anschlüssen aktiv entladen werden, wobei die Gate-Anschlüsse über ein oder mehrere Bauteile entladen werden, die nicht zur Aufladung der Kapazitäten verwendet werden.

3. Verfahren nach Anspruch 1 oder 2, **dadurch gekennzeichnet, dass** die gedämpfte Schwingung nach einer Schwingungsperiode oder nach einer halben Schwingungsperiode abgebrochen wird.

4. Verfahren nach einem der beiden vorherigen Ansprüche, **dadurch gekennzeichnet, dass** die gedämpfte Schwingung abgebrochen wird, indem die Halbleiterelemente (4) in einen zweiten Zustand geschaltet werden, wobei die elektrische Verbindung zwischen dem elektrischen Energiespeicher und dem elektrischen System getrennt ist, wenn die Halbleiterelemente (4) im zweiten Zustand sind.

5. Verfahren nach dem vorherigen Anspruch, **dadurch gekennzeichnet, dass** die Halbleiterelemente (4) in den zweiten Zustand geschaltet werden, indem die Kapazität des Gate-Anschlusses der Halbleiterelemente (4) jeweils elektrisch entladen wird.

6. Verfahren nach dem vorherigen Anspruch, **dadurch gekennzeichnet, dass** die Kapazität des Gate-Anschlusses über jeweils einen Thyristor oder einen Transistor, und einen Entladewiderstand entladen wird.

7. Verfahren nach einem der vorherigen Ansprüche, **dadurch gekennzeichnet, dass** die gedämpfte Schwingung nach Ablauf einer Zeitspanne abgebrochen wird, wobei die Zeitspanne durch eine Entladung eines Verzögerungsglieds definiert ist.

8. Verfahren nach dem vorherigen Anspruch, **dadurch gekennzeichnet, dass** der Energiespeicher während der Abgabe des Spannungsstoßes nachgeladen wird, und wobei das Verzögerungsglied bei einer Nachladung des Energiespeichers ebenfalls nachgeladen wird.

9. Verfahren nach einem der vorherigen Ansprüche, **dadurch gekennzeichnet, dass** nach dem Abbruch der gedämpften Schwingung und/oder nach der Entladung der Kapazitäten der Gate-Anschlüsse ein weiterer elektrischer Spannungsstoß an das elektrische System über die beiden elektrischen Kontakte des elektrischen Systems abgegeben wird.

10. Verfahren nach einem der vorherigen Ansprüche, **dadurch gekennzeichnet, dass** der Spannungsstoß eine Spannung von mehr als 500 V aufweist.

11. Vorrichtung zur Stoßspannungsprüfung eines elektrischen Systems, umfassend mehrere Halbleiterelemente (4), einen Energiespeicher, Anschlüsse für eine elektrische Verbindung der Vorrichtung mit dem elektrischen System, erste Mittel (3) zur Schaltung der Halbleiterelemente (4) in einen ersten Zustand und zweite Mittel (6) zur Schaltung der Halbleiterelemente (4) in einen zweiten Zustand, wobei der Energiespeicher im ersten Zustand der Halbleiterelemente (4) elektrisch mit den Anschlüssen verbunden ist, wobei der Energiespeicher im zweiten Zustand der Halbleiterelemente (4) zumindest von einem der Anschlüsse getrennt ist, **dadurch gekennzeichnet, dass** die Vorrichtung dazu ausgebildet ist, ein Verfahren nach einem der vorherigen Ansprüche auszuführen.

12. Vorrichtung nach dem vorherigen Anspruch, **dadurch gekennzeichnet, dass** die Halbleiterelemente (4) als Transistoren (4) ausgebildet sind, wobei die Transistoren (4) jeweils einen Gate-Anschluss aufweisen, wobei die ersten Mittel (3) und die zweiten Mittel (6) jeweils mit dem jeweiligen Gate-Anschluss der Transistoren (4) elektrisch verbunden sind.

13. Vorrichtung nach dem vorherigen Anspruch, **dadurch gekennzeichnet, dass** die zweiten Mittel (6) dazu ausgebildet sind, jeweils die Kapazität des Gate-Anschlusses der Transistoren (4) elektrisch zu entladen.

## Claims

1. Method for surge voltage testing of an electrical system, comprising the following steps:
- delivering an electrical voltage surge to the electrical system via at least two electrical contacts of the electrical system, wherein the delivery of the voltage surge is triggered by a switching of semiconductor elements (4) into a first state, wherein the semiconductor elements (4) in the first state electrically connect an electrical energy store to the electrical system, wherein the semiconductor elements (4) each have a gate connection, wherein in each case a capacitance at the gate connection is charged when the semiconductor elements (4) are switched into the first state;
- measuring a voltage profile between the two electrical contacts directly after the delivery of the voltage surge, wherein the voltage profile comprises a damped oscillation;
- analyzing the measured voltage profile in order to detect partial discharges in the electrical system;
**characterized in that**
- the damped oscillation is actively aborted.

2. Method according to Claim 1, **characterized in that** the capacitances at the gate connections are actively discharged, wherein the gate connections are discharged via one or more components which are not used for charging the capacitances.

3. Method according to Claim 1 or 2, **characterized in that** the damped oscillation is aborted after one oscillation period or after half an oscillation period.

4. Method according to either of the two preceding claims, **characterized in that** the damped oscillation is aborted by the semiconductor elements (4) being switched into a second state, wherein the electrical connection between the electrical energy store and the electrical system is disconnected when the semiconductor elements (4) are in the second state.

5. Method according to the preceding claim, **characterized in that** the semiconductor elements (4) are switched into the second state by the capacitance of the gate connection of the semiconductor elements (4) being electrically discharged in each case.

6. Method according to the preceding claim, **characterized in that** the capacitance of the gate connection is discharged via in each case a thyristor or a transistor and a discharge resistor.

7. Method according to one of the preceding claims, **characterized in that** the damped oscillation is aborted after a time period has elapsed, wherein the time period is defined by a discharge of a delay element.

8. Method according to the preceding claim, **characterized in that** the energy storage is recharged during the delivery of the voltage surge, and wherein the delay element is likewise recharged during a recharging of the energy storage.

9. Method according to one of the preceding claims, **characterized in that**, after the damped oscillation has been aborted and/or after the capacitances of the gate connections have been discharged, a further electrical voltage surge is delivered to the electrical system via the two electrical contacts of the electrical system.

10. Method according to one of the preceding claims, **characterized in that** the voltage surge has a voltage of more than 500 V.

11. Device for surge voltage testing of an electrical system, comprising a plurality of semiconductor elements (4), an energy storage, connections for an electrical connection of the device to the electrical system, first means (3) for switching the semiconductor elements (4) into a first state and second means (6) for switching the semiconductor elements (4) into a second state, wherein the energy storage is electrically connected to the connections in the first state of the semiconductor elements (4), wherein the energy storage is separated from at least one of the connections in the second state of the semiconductor elements (4), **characterized in that** the device is designed to carry out a method according to one of the preceding claims.

12. Device according to the preceding claim, **characterized in that** the semiconductor elements (4) are designed as transistors (4), wherein the transistors (4) each have a gate connection, wherein the first means (3) and the second means (6) are each electrically connected to the respective gate connection of the transistors (4).

13. Device according to the preceding claim, **characterized in that** the second means (6) are designed to electrically discharge the capacitance of the gate connection of the transistors (4) in each case.

## Revendications

1. Procédé de contrôle de la tension de choc d'un système électrique, comprenant les étapes suivantes :
- délivrance d'un choc de tension électrique au système électrique par le biais d'au moins deux contacts électriques du système électrique, la délivrance du choc de tension étant déclenchée par une commutation d'éléments semi-conducteurs (4) dans un premier état, les éléments semi-conducteurs (4) dans le premier état reliant électriquement un accumulateur d'énergie électrique au système électrique, les éléments semi-conducteurs (4) présentant à chaque fois une borne de grille, une capacité à la borne de grille étant à chaque fois chargée lorsque les éléments semi-conducteurs (4) sont commutés dans le premier état ;
- mesure d'une courbe de tension entre les deux contacts électriques directement après la délivrance du choc de tension, la courbe de tension comprenant une oscillation amortie ;
- analyse de la courbe de tension mesurée pour détecter des décharges partielles dans le système électrique ;
**caractérisé en ce que**
- l'oscillation amortie est interrompue activement.

2. Procédé selon la revendication 1, **caractérisé en ce que** les capacités aux bornes de grille sont déchargées activement, les bornes de grille étant déchargées par le biais d'un ou de plusieurs composants qui ne sont pas utilisés pour la charge des capacités.

3. Procédé selon la revendication 1 ou 2, **caractérisé en ce que** l'oscillation amortie est interrompue après une période d'oscillation ou après une demi-période d'oscillation.

4. Procédé selon l'une quelconque des deux revendications précédentes, **caractérisé en ce que** l'oscillation amortie est interrompue par le fait que les éléments semi-conducteurs (4) sont commutés dans un deuxième état, la liaison électrique entre l'accumulateur d'énergie électrique et le système électrique étant séparée lorsque les éléments semi-conducteurs (4) sont dans le deuxième état.

5. Procédé selon la revendication précédente, **caractérisé en ce que** les éléments semi-conducteurs (4) sont commutés dans le deuxième état par le fait que la capacité de la borne de grille des éléments semi-conducteurs (4) est à chaque fois déchargée électriquement.

6. Procédé selon la revendication précédente, **caractérisé en ce que** la capacité de la borne de grille est à chaque fois déchargée par le biais d'un thyristor ou d'un transistor et d'une résistance de décharge.

7. Procédé selon l'une quelconque des revendications précédentes, **caractérisé en ce que** l'oscillation amortie est interrompue après l'écoulement d'un laps de temps, le laps de temps étant défini par une décharge d'un élément de temporisation.

8. Procédé selon la revendication précédente, **caractérisé en ce que** l'accumulateur d'énergie est rechargé pendant la délivrance du choc de tension, et l'élément de temporisation étant également rechargé lors d'une recharge de l'accumulateur d'énergie.

9. Procédé selon l'une quelconque des revendications précédentes, **caractérisé en ce qu'**après l'interruption de l'oscillation amortie et/ou après la décharge des capacités des bornes de grille, un autre choc de tension électrique est délivré au système électrique par le biais des deux contacts électriques du système électrique.

10. Procédé selon l'une quelconque des revendications précédentes, **caractérisé en ce que** le choc de tension présente une tension de plus de 500 V.

11. Dispositif de contrôle de la tension de choc d'un système électrique, comprenant plusieurs éléments semi-conducteurs (4), un accumulateur d'énergie, des bornes pour une connexion électrique du dispositif au système électrique, des premiers moyens (3) pour commuter les éléments semi-conducteurs (4) dans un premier état et des deuxièmes moyens (6) pour commuter les éléments semi-conducteurs (4) dans un deuxième état, l'accumulateur d'énergie étant connecté électriquement aux bornes dans le premier état des éléments semi-conducteurs (4), l'accumulateur d'énergie étant séparé dans le deuxième état des éléments semi-conducteurs (4) au moins de l'une des bornes, **caractérisé en ce que** le dispositif est réalisé pour mettre en œuvre un procédé selon l'une quelconque des revendications précédentes.

12. Dispositif selon la revendication précédente, **caractérisé en ce que** les éléments semi-conducteurs (4) sont réalisés sous forme de transistors (4), les transistors (4) présentant à chaque fois une borne de grille, les premiers moyens (3) et les deuxièmes moyens (6) étant à chaque fois connectés électriquement à la borne de grille respective des transistors (4).

13. Dispositif selon la revendication précédente, **caractérisé en ce que** les deuxièmes moyens (6) sont réalisés pour décharger électriquement à chaque fois la capacité de la borne de grille des transistors (4).
